# NEUE EUROPÄISCHE PATENTSCHRIFT

(11) **EP 2 983 276 B2**
(45) Veröffentlichungstag und Bekanntmachung des Hinweises auf die Entscheidung über den Einspruch: **29.01.2020**
(45) Hinweis auf die Patenterteilung: 26.04.2017
(21) Anmeldenummer: 14179653.2
(22) Anmeldetag: 04.08.2014
(51) Int. Cl.: G01R 31/34, G01R 31/12, H02K 11/20, H02K 3/38

(54) **Dynamoelektrische Maschine mit einer Isolationsüberwachung**
Dynamo-electric machine with an insulation monitoring system
Machine dynamoélectrique dotée d'un dispositif de surveillance d'isolation

(43) Veröffentlichungstag der Anmeldung: 10.02.2016
(73) Patentinhaber: Siemens Aktiengesellschaft, 80333 München (DE)
(72) Erfinder: Lampe, Robert, 90599 Dietenhofen (DE)

(56) Entgegenhaltungen:
- EP-A1- 1 503 218
- EP-A1- 2 549 245
- EP-A2- 2 479 583
- WO-A2-2014/114673
- DD-A1- 205 540
- DE-A1-102011 082 358
- JP-A- H02 184 204
- JP-A- H02 184 204
- JP-A- S55 122 450
- KR-A- 20040 075 187
- US-A1- 2007 194 631
- US-A1- 2007 194 631
- G.C. STONE: "Advancements during the Past Quarter Century on On-line Monitoring of Motor and Generator Winding Insulation", IEEE Transactions on Dielectrics and Electrical Insulation, vol. 9, no. 5, October 2002 (2002-10),

## Beschreibung

Dynamoelektrische Maschine mit einer Isolationsüberwachung Die Erfindung betrifft eine luftgekühlte dynamoelektrische Maschine, insbesondere eine durchzugsbelüftete rotatorische Maschine mit einem Stator, der axialgeschichtete Bleche aufweist, wobei das Blechpaket Nuten aufweist mit einem im wesentlichen axialen Verlauf, wobei diese Nuten im Bereich des Luftspaltes der dynamoelektrischen rotatorischen Maschine angeordnet sind und wobei ein Wicklungssystem, das in den Nuten positioniert ist und an der Stirnseite des Stators Wickelköpfe ausbildet, überwacht wird.

Insbesondere Wickelköpfe luftgekühlter dynamoelektrischer Maschinen, die sich an den Stirnseiten eines Stators axial erstrecken, sind im Bereich von Luftströmungen angeordnet und damit einem Partikelstrom ausgesetzt, der sich innerhalb dieses Luftstromes befindet. Dabei wird insbesondere der Wickelkopf einem dementsprechenden Bombardement von Luftpartikeln und Staubpartikeln ausgesetzt, die zu Abrasionen der Isolation des Wickelkopfes führen und damit den Betrieb der dynamoelektrische Maschine beeinträchtigen können.

Die Druckschrift JP 55122450 offenbart ein Sensorsystem, das auf der Isolationsschicht einer elektrischen Maschine angebracht ist, um einen Isolationsdurchschlag zu lokalisieren.

Die Druckschrift WO 2014/114673 A2 offenbart eine Isolationsüberwachung, die einen Wicklungskurzschluss in Folge von erhöhter Temperatur frühzeitig detektieren soll.

Ausgehend davon liegt der Erfindung die Aufgabe zugrunde, die Isolation des Wicklungssystems, insbesondere des Wickelkopfes einer dynamoelektrischen Maschine zu überwachen.

Die Lösung der gestellten Aufgabe gelingt durch eine luftgekühlte dynamoelektrische Maschine gemäß den Merkmalen des Anspruchs 1. Ferner wird diese Aufgabe durch ein Verfahren nach Anspruch 5 gelöst.

Somit meldet sich das Überwachungssystem bereits vor dem Ausfall der Isolation, also des Isolationssystems an neuralgischen Punkten, die aufgrund der Luftkühlung einem Partikelstrom ausgesetzt ist. Somit wird also insbesondere die Isolation am Wickelkopf der dynamoelektrischen Maschine überwacht, bevor die Maschine ausfällt und dementsprechende Einbußen zu erleiden sind.

Auf die erfindungsgemäße Art und Weise kann selbstverständlich auch das Wicklungssystem der dynamoelektrischen Maschine in den Nuten überwacht werden.

Vorteilhafterweise werden derartige Mittel in Isolationsschichten an besonders neuralgischen Stellen des Wickelkopfes vorgesehen, an denen beispielsweise der Kühlluftstrom zuerst auf Elemente der dynamoelektrischen Maschine trifft oder auch bei der eine interne Verteilung des Kühlluftstromes verstärkt zu einen Partikelstrom auf gewisse Teile des Wicklungssystem, in diesem Fall des Wicklungskopfes führt.

Somit muss nicht zwangsläufig der gesamte Wickelkopf mit den Mitteln zur Überwachung, also den Überwachungselementen versehen sein, sondern je nach Maschinendesign sind nur gewisse Punkte am Wickelkopf oder gewisse Flächenbereiche am Wickelkopf zu überwachen, die sich aufgrund des Maschinendesigns als besonders kritisch herausstellen, da sie dem Partikelstrom verstärkt ausgesetzt sind.

Erfindungsgemäß werden die Mittel zur Überwachung als Lichtwellenleiteranordnung ausgeführt, bei der ein oder mehrere Leiter innerhalb des Isolationssystems am Wickelkopf vorgesehen werden, die ebenso dem Partikelstrom der Luftströmung ausgesetzt sind. Die Isolation des Lichtwellenleiters ist damit ebenso der Abrasion ausgesetzt und wird dabei zwangsläufig durch den Partikelstrom ebenso beansprucht, d.h. im Extremfall unterbrochen bzw. durchtrennt.

Damit verändert sich der Brechungsindex der Lichtwellenleiter.

Dabei ist sowohl ein serielles als auch paralleles Verlegen dieser Lichtwellenleiter möglich.

Ebenso können diese Lichtwellenleiter in dem angestrebten Überwachungsgebiet des Wickelkopfes mäanderförmig verlegt sein.

Diese Veränderung, im worst-case Durchtrennung des Lichtwellenleiters wird dann messtechnisch erfasst und kann als Indiz einer erhöhten Isolationsbeanspruchung bzw. -Abnutzung der Isolation des Wickelkopfes gewertet werden.

In einer weiteren Ausführungsform wird dieses System durch mehrere, ausgehend vom Wickelkopf, radial übereinander liegende Lichtwellenleiter in der Isolation des Wickelkopfes eingebettet. Damit liegt ein gestuftes Sicherheitskonzept der Isolationsüberwachung vor, die dementsprechende abgestufte Meldungen beinhaltet, die ein Zeitmanagement des weiteren Betriebs der elektrischen Maschine gestatten.

Beispielsweise lässt sich somit bei einem gestuften Konzept erkennen, dass nach ca. zwei Jahren die erste Stufe anspricht, nach weiteren zwei Jahren die zweite Stufe und dass dann mit einer linearen Hochrechnung und bei ähnlichen Betriebsbedingungen davon auszugehen ist, dass beispielsweise dann bei vorgesehenen drei Schichten nunmehr die Isolation des Wickelkopfes gefährdet ist und eine Wartung und Überarbeitung der Isolation des Wickelkopfes der dynamoelektrischen Maschine stattfinden muss.

Auf die erfindungswesentliche Art und Weise wird also eine Schichtdickenmessung der elektrischen Isolation des Wicklungssystems, insbesondere an besonders exponierten Stellen des Wickelkopfs vorgenommen.

Bzgl. der Überwachung des Isolationszustandes des Wickelkopfes der dynamoelektrischen Maschine lässt sich somit ein Ampelstatus, Warntöne oder andere optische und/oder akustische Signale einrichten.

Die Überwachung kann auf mehrere Art und Weise von statten gehen. Zum einen werden die Lichtwellenleiter außerhalb des Motorgehäuses geführt um dort beispielsweise von Servicemitarbeitern auf Durchgang geprüft zu werden. Bei der Lichtwellenleiteranordnung wird für die Überprüfung des Isolationswiderstandes am Wickelkopf ein Lichtmessgerät eingesetzt.

In einer weiteren, automatisierten Vorgehensweise dieser Überwachung wird über ein Steuermodul, das beispielsweise im Umrichter oder direkt an der elektrischen Maschine positioniert sein kann, in vorgegebenen Zeitabständen ein dementsprechendes Messsignal auf den Lichtwellenleiter gegeben. Mit dem Rücksignal werden dann dementsprechende Messwerte bzw. Meldungen beispielsweise in einem Speicher hinterlegt, die jederzeit abrufbar sind.

Die Messdaten werden in einer weiteren Ausführungsform an eine Leitstelle weitergegeben, klassifiziert und ausgewertet.

Diese Meldungen des Isolationswiderstandes, insbesondere am Wickelkopf können an sämtliche übergeordneten Systemsteuerungen beispielsweise bei Triebzügen oder Mining-Trucks leitungsgebunden oder wireless z.B. per Funk übermittelt werden, um so beispielsweise für den Fahrer und/oder einer Leitstelle Meldungen über den Zustand des Isolationssystems und damit des Antriebssystems bereitzustellen.

Die Erfindung sowie weitere beispielhafte Ausgestaltungen sind im dargestellten Ausführungsbeispiel prinzipiell zu entnehmen, darin zeigen:
- FIG 1: einen Längsschnitt einer durchzugsbelüfteten dynamoelektrischen rotatorischen Maschine,
- FIG 2 bis 4: Anordnung der Mittel zur Überwachung am Wickelkopf,
- FIG 5 und 6: Anordnungen der Drähte bzw. Lichtwellenleiter in einer Zwischenschicht,
- FIG 7: Antrieb eines Mining-Trucks, der spezielle Luftführungen aufweist,
- FIG 8: Antrieb einer Lok,
- FIG 9: Anordnung der Mittel zur Überwachung im Wickelkopf.

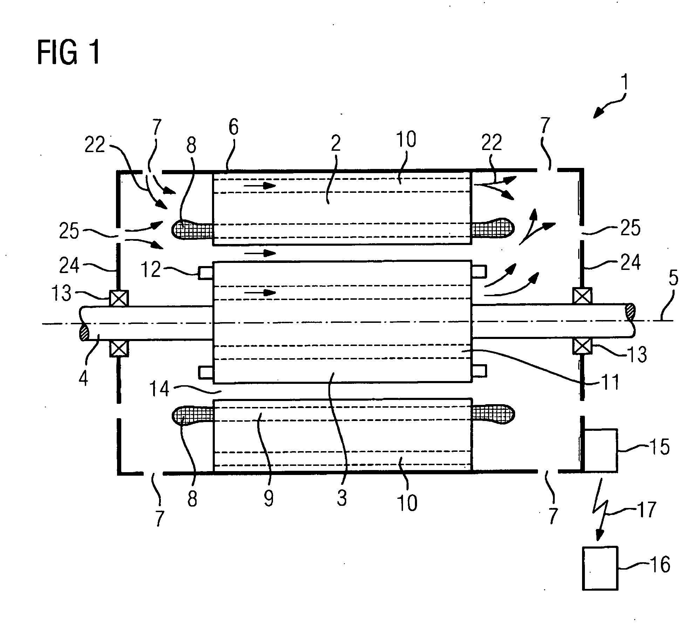

FIG 1 zeigt in einem prinzipiellen Längsschnitt eine dynamoelektrische rotatorische durchzugsbelüftete Maschine 1, die einen Stator 2 und einen Rotor 3 aufweist, wobei der Rotor 3 mit einer Welle 4 drehfest verbunden ist und um eine Achse 5 drehbar gelagert ist.

Die Welle 4 wird dabei prinzipiell auf beiden Seiten der Aktivteile, also des Stators 2 und des Rotors 3 von einem Lager 13 gehalten, wobei das Lager 13 durch ein Lagerschild 24 jeweils positioniert ist. Das Lagerschild 24 wiederum ist in einem Gehäuse 6 gehalten, dessen Außenwandungen sich in diesem speziellen Fall achsparallel erstrecken.

Der Stator 2 weist axial geschichtete Bleche auf, wobei das Blechpaket Nuten 9 aufweist, mit einem im wesentlichen axialen Verlauf, wobei diese Nuten 9 im Bereich des Luftspaltes 14 der dynamoelektrischen rotatorischen Maschine 1 angeordnet sind. Der Stator 2 weist ein Wicklungssystem in diesen Nuten 9 auf, das an den Stirnseiten des Blechpakets des Stators 2 Wickelköpfe 8 ausbildet.

Im Betrieb der dynamoelektrischen rotatorischen Maschine 1 tritt aufgrund der elektromagnetischen Wechselwirkung des Wicklungssystems mit dem Rotor 3 eine Drehung (bei motorischem Betrieb), oder eine Energieerzeugung (bei generatorischem Betrieb), der dynamoelektrischen rotatorischen Maschine 1 ein.

Der Stator 2 weist achsparallel verlaufende Kühlkanäle 10 auf, die in Umfangsrichtung betrachtet gleichmäßig verteilt angeordnet sind. Die Kühlkanäle 10 sind vorzugsweise rund oder rundlich ausgestaltet, können aber auch andere geometrische Querschnittsformen, wie sternförmig, dreieckförmig etc. aufweisen.

Der Rotor 3 ist als Kurzschlussläufer ausgebildet, wobei sich an den Stirnseiten des Rotors 3 dem Luftspalt 14 zugewandt ein Kurzschlusskäfig befindet, der an den Stirnseiten des Rotors 3 Kurzschlussringe 12 ausbildet. Zwischen dem Kurzschlusskäfig des Rotors 3 und der Welle 4 sind im Umfangsrichtung verteilt einer oder mehrere axial verlaufende Kühlkanäle 11 angeordnet, die auch im Stator 2 vorgesehen werden können. Das Gehäuse 6 und/oder das Lagerschild 24 weisen Öffnungen 7 bzw. 25 auf, durch die ein - vorzugsweise erzwungener - Luftaustausch mit der Umgebung stattfindet. Diese Öffnungen 7 bzw. 25 können durch Filtermatten oder dergleichen abgedeckt sein, um eine Vorfilterung der Kühlluft zu schaffen.

Die Luftströmungen werden dabei von einem oder mehreren Lüfter gewährleistet. Es liegt eine Selbst- und/oder Fremdkühlung vor.

FIG 1 zeigt beispielhaft einen Kühlluftstrom 22, wie er in die dynamoelektrische rotatorische Maschine 1 eindringt, sich über die axial verlaufenden Kühlkanäle 10, 11 und den Luftspalt 14 erstreckt und wie der erwärmte Kühlluftstrom wieder durch Öffnung 7 und 25 das Gehäuse 6 bzw. die rotatorische dynamoelektrische Maschine 1 verlässt. Aus Übersichtlichkeitsgründen ist ein beispielhafter Kühlluftstromverlauf nur in der oberen Hälfte dieser Figur 1 dargestellt.

Mit dem in die Maschine 1 eintretenden Kühlluftstrom werden Partikel mit eingeführt, die je nach Geschwindigkeit des Kühlluftstroms 22 mehr oder weniger intensiv insbesondere auf den Wickelkopf 8 prallen. Aufgrund der vergleichsweise geringen Wärmekapazität von Luft ist, um eine dementsprechende Kühlwirkung der dynamoelektrischen Maschine 1 zu erhalten, ein ausreichender Volumendurchsatz durch die Maschine zu gewährleisten.

Aufgrund des angestrebten Volumendurchsatzes und der damit verbundenen hohen Geschwindigkeit des von außen zugeführten Kühlluftstromes erreichen auch die durch die Kühlluft mitgeführten Partikel vergleichsweise hohe Geschwindigkeiten und prallen insbesondere auf den Wickelkopf 8 besonders auf die Isolierung des Wickelkopfes 8. Dies führt, insbesondere bei dementsprechender z.B. staubhaltiger Betriebsumgebung zu einem vorschnellen Verschleiß der Isolierung des Wickelkopfes 8. Aufgrund der unterschiedlichen Phasen des Wicklungssystems, die sich im Wickelkopf 8 überkreuzen und/oder überlappen führt dies zu einem Ausfall der dynamoelektrischen Maschine 1.

In vorteilhafter Weise wird nunmehr in dem Wickelkopf 8 oder unmittelbar an dem Wickelkopf 8 ein Überwachungselement 20, also Mittel zur Überwachung vorgesehen, zumindest ein Draht und/oder zumindest ein Lichtwellenleiter verlegt, der ebenfalls dem Abrasionsprozess unterworfen ist. Sobald nunmehr der Draht oder der Lichtwellenleiter von den Partikeln angegriffen wird, wird dementsprechend der ohmsche Widerstand respektive das durch den Lichtwellenleiter fallende Licht verändert, was im Rahmen einer Überprüfung als eindeutiges Indiz auf die anstehende nachlassende Isolationseigenschaften der Isolation am Wickelkopf 8 hinweist.

Als alternative Ausführungsform können derartige Drähte bzw. Lichtwellenleiter in einer eigens vorzusehenden Zusatzschicht 19 am Wickelkopf 8 angebracht werden, die aufgrund der beschriebenen physikalischen Gegebenheiten zu einer Meldung des Isolationsverlustes führen. Die Drähte und/oder Lichtwellenleiter sind in einer oder mehreren Lagen in der Zusatzschicht 19 angeordnet, die unmittelbar am Wickelkopf 8 auf der Isolation des Wickelkopfes befestigt, vorzugsweise geklebt oder durch Bandage gehalten wird.

Bei einer im Wesentlichen automatisierten Überwachung wird über ein Steuermodul 15, das beispielsweise im Umrichter oder direkt an der elektrischen Maschine 1 positioniert sein kann, in vorgegebenen Zeitabständen ein dementsprechendes Messsignal auf den Draht- bzw. Lichtwellenleiter gegeben. Mit dem Rücksignal werden dann dementsprechende Messwerte bzw. Meldungen beispielsweise in einem Speicher im oder am Steuermodul 15 hinterlegt, die dort jederzeit abrufbar sind.

Die Messdaten werden in einer weiteren Ausführungsform an eine Leitstelle 16 beispielsweise per Funk 17 weitergegeben, klassifiziert und ausgewertet.

Diese Meldungen des Isolationswiderstandes, insbesondere am Wickelkopf 8 können an sämtliche übergeordneten Systemsteuerungen beispielsweise bei Triebzügen oder Mining-Trucks übermittelt werden, um so insbesondere für den Fahrer und/oder einer Leitstelle 16 Meldungen über den Zustand seines Antriebssystems, insbesondere des Isolationssystems bereitzustellen.

Damit ist eine nahezu permanente Zustandsüberwachung der Isolation des Wickelkopfes 8 möglich und eine zeitige Fehlererkennung gegeben. Damit lassen sich isolationsbedingte Ausfälle von dynamoelektrischen Maschinen 1 bei sämtlichen Anwendungsfällen derartiger Maschinen vermeiden.

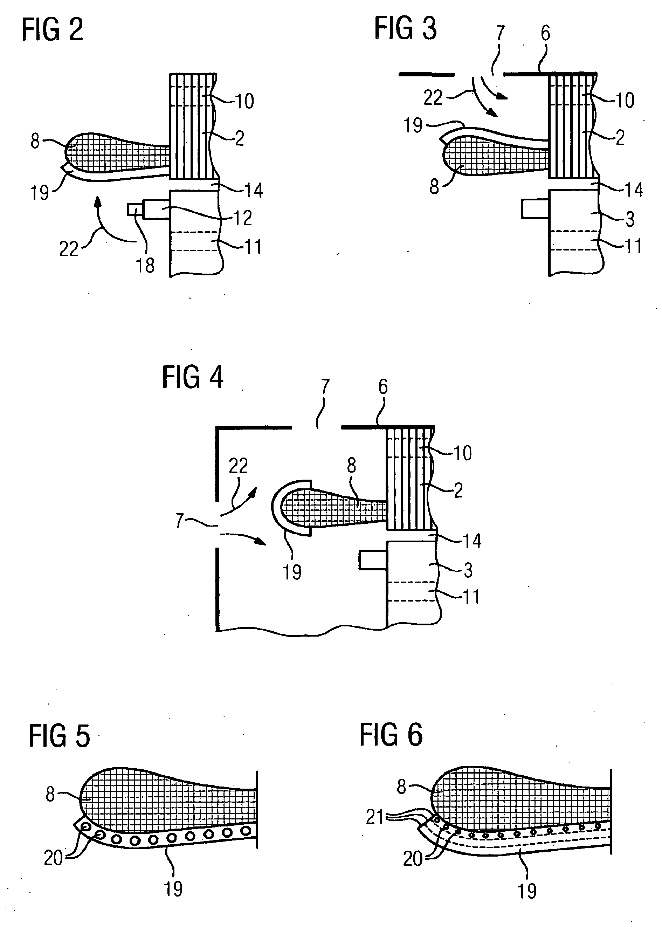

FIG 2 zeigt beispielhaft eine Anordnung einer derartigen Zusatzschicht 19 an der dem Luftspalt 14 zugewandten Seite des Wickelkopfes 8. Dies ist insbesondere dann von Bedeutung, falls am Kurzschlussring 12 ein zusätzlicher Lüfterflügel 18 angebracht sein sollte, der insbesondere für eine radiale Kühlluftführung und damit ein verstärktes Aufprallen der Partikel des Kühlluftstromes an der dort markierten Stelle des Wickelkopfes 8 führt. Damit wird nunmehr durch die Zusatzschicht 19 oder dort in das Isolationsmaterial eingelassene Drähte und Lichtwellenleiter die Isolierung des Wickelkopfes 8 überwacht.

FIG 3 zeigt in einer anderen Führungsform einen anderen Eintritt/Verlauf der Kühlluft 22. Auch dort wird aufgrund der erhöhten Abrasion auf der Oberseite des Wickelkopfes 8 dieser Bereich des Wickelkopfes 8 punktuell oder flächenmäßig überwacht.

FIG 4 zeigt in einer weiteren Anordnung bei axialem Anströmen die zu schützende Schicht des Wickelkopfes 8, was ebenfalls durch eine Zusatzschicht 19 mit Drähten und Lichtwellenleitern oder auch durch bereits in den Wickelkopf 8 eingelassene Drähte und Lichtwellenleiter erfolgen kann.

FIG 5 zeigt in einer detaillierteren Darstellung den Aufbau einer derartigen Zusatzschicht 19, die mehrere Einzeldrähte 20 oder Lichtwellenleiter enthält und die speziell gemäß der Ausführung nach FIG 2 am Wickelkopf 8 angebracht ist.

Um kaskadenförmige Meldungen zu erhalten, die die unterschiedlichen Abrasionszustände des Wickelkopfes 8 wiedergeben, können entweder mehrere Einzelschichten oder mehrere in einer Schicht hintereinander geschalteten Lagen von Drähten oder Lichtwellenleitern angeordnet sind. Die prinzipielle Darstellung dieser gemäß FIG 5 und FIG 6 dargestellten Anordnungen lässt sich auch auf die Darstellung gemäß FIG 3 und FIG 4 übertragen.

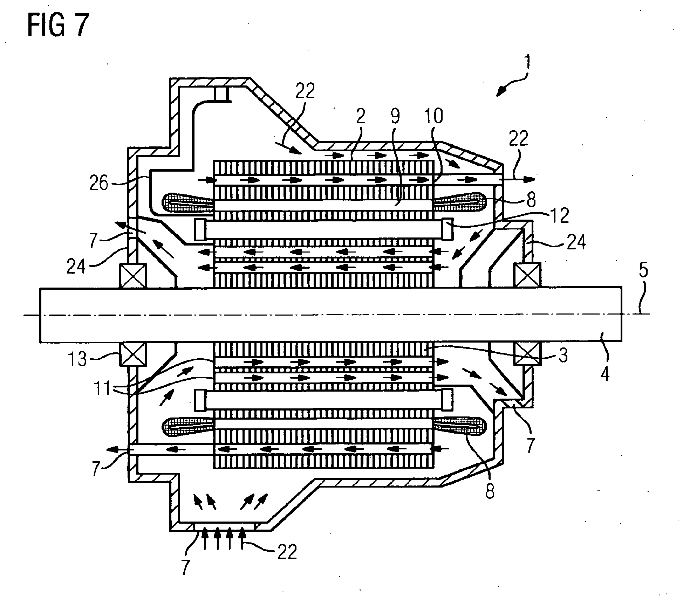

Die Anwendung eines derartigen Überwachungselements der Isolation beispielsweise durch Abrasion kann auch FIG 7 entnommen werden, wo beispielsweise ein Antrieb eines Mining-Trucks dargestellt ist. Im Prinzip entspricht dieser Motor im Wesentlichen dem in FIG 1, nur dass gewisse Luftführungskanäle speziell ausgebildet sind und ein Kühlluftstrom 22 gegebenenfalls auch über einen nicht näher dargestellten Klemmenkasten des Motors geführt wird.

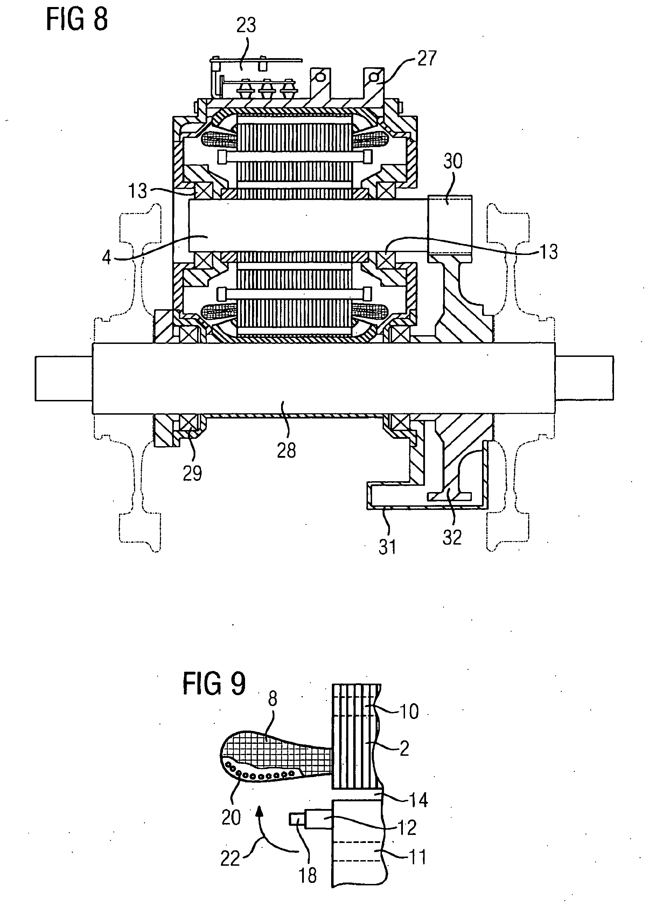

FIG 8 zeigt ein weiteres Einsatzgebiet einer derartigen dynamoelektrischen Maschine 1 nach FIG 1 bei einem Antrieb einer Lok, wobei die dynamoelektrische Maschine 1 über die Welle 4 ein Ritzel 30 und damit ein Großrad 32 antreibt. Der Antrieb ist dabei über eine Drehmomentenstütze 27 mit einem nicht näherdargestellten Drehgestell verbunden. Das Großrad 32 ist drehfest mit einer Radsatzwelle 28 verbunden, die wiederum mit den Rädern einer Lok (gestrichelt dargestellt) drehfest verbunden ist. Sowohl die Radsatzwelle 28 als auch die Welle 4 sind separat über Tatzlager 29 bzw. Lager 13 gelagert. Das Großrad 32 läuft in einem Getriebegehäuse 31, in dem auch die Mittel zur Schmierung des Großrades 32 vorgesehen sind.

Aus Übersichtlichkeitsgründen ist der Lokantrieb nur prinzipiell dargestellt, ebenso wie dort auch auf die Darstellung der einzelnen Kühlluftströme verzichtet wurde.

FIG 9 zeigt in Anlehnung an FIG 2 in einer weiteren Darstellung die Anordnung der Drähte oder Lichtwellenleiter in der Isolation des Wickelkopfes 8 eingebettet. Dort sind die Drähte oder Lichtwellenleiter möglichst an der Oberfläche der Isolation des Wickelkopfes 8 angeordnet, um möglichst frühzeitig die Abrasion und damit die Reduzierung der Isolation feststellen zu können.

Für die Überwachung der Isolation des Wickelkopfes 8 gelten im Übrigen sinngemäß die für die oben genannten Ausführungsformen getroffenen Aussagen u.a. betreffend die Anordnungen und die Messmethodik. Ebenso kann das stufenweise Überwachungskonzept, die Überprüfung der Isolation und die Anwendung bei Miningtrucks und Bahnantrieben gemäß der obigen Ausführungen bei der Anordnung nach FIG 9 umgesetzt werden.

Grundsätzlich sind die Merkmale der oben beschriebenen Ausführungen auch miteinander kombinierbar.

## Patentansprüche

1. Luftgekühlte dynamoelektrische Maschine (1), insbesondere durchzugsbelüftete dynamoelektrische Maschine (1), mit einem Stator (2), mit einem Wicklungssystem, das an den Stirnseiten des Stators (2) Wickelköpfe (8) ausbildet, wobei zumindest der Wickelkopf (8) in seiner Isolationsschicht zumindest ein Überwachungselement (20) zur Überwachung der Isolationsstärke des Wickelkopfes (8) aufweist, wobei das Überwachungselement (20) zumindest eine Lichtwellenleiteranordnung aufweist.

2. Luftgekühlte dynamoelektrische Maschine (1) nach Anspruch 1, **dadurch gekennzeichnet, dass** das Überwachungselement (20) zumindest an der Stelle des Wickelkopfes (8) vorgesehen ist, die einem Kühlluftstrom (22) ausgesetzt ist.

3. Luftgekühlte dynamoelektrische Maschine (1) nach Anspruch 1 oder 2, **dadurch gekennzeichnet, dass** das Überwachungselement (20) zumindest eine Drahtanordnung aufweist.

4. Luftgekühlte dynamoelektrische Maschine (1) nach einem der vorhergehenden Ansprüche, **dadurch gekennzeichnet, dass** über das Überwachungselement (20) eine Zustandserkennung des Isolationswiderstandes am Wickelkopf (8) stattfindet.

5. Verfahren zur Überprüfung des Isolationszustandes eines Wicklungskopfes (8) einer luftgekühlten dynamoelektrischen Maschine (1) insbesondere durchzugsbelüfteten dynamoelektrischen Maschine (1) mit einem Stator (2), mit einem Wicklungssystem, das an den Stirnseiten des Stators (2) Wickelköpfe (8) ausbildet, wobei zumindest der Wickelkopf (8) in seiner Isolationsschicht mindestens ein Überwachungselement (20) zur Überwachung der Isolationsstarkedes Wickelkopfes (8) aufweist, wobei das Überwachungselement (20) zumindest eine Lichtwellenleiteranordnung aufweist, nach einem der vorhergehenden Ansprüche durch folgende Schritte:
- in vorgebbaren Zeitabständen werden Signale in das Überwachungselement (20) geschickt,
- Aufnahme der Rücksignale aus dem Überwachungselement (20),
- Auswertung der Rücksignale derart, dass Rückschlüsse auf den Isolationszustand des Wickelkopfes (8) vorgenommen werden.

6. Verfahren zur Überprüfung des Isolationswiderstandes nach Anspruch 5, **dadurch gekennzeichnet, dass** über die Aufnahme der Rücksignale eine Klassifizierung des Isolationszustands des Wicklungskopfes (8) stattfindet.

## Claims

1. Air-cooled dynamo-electric machine (1), in particular an enclosed-ventilated dynamo-electric machine (1), having a stator (2) with a winding system which forms end windings (8) at the end faces of the stator (2), wherein at least the end winding (8) has at least one monitoring element (20) in its insulation layer for the purpose of monitoring the insulation thickness of the end winding (8), wherein the monitoring element (20) comprises at least one optical fibre arrangement.

2. Air-cooled dynamo-electric machine (1) according to claim 1, **characterised in that** the monitoring element (20) is provided at least at that point of the end winding (8) which is exposed to a cooling air stream (22).

3. Air-cooled dynamo-electric machine (1) according to claim 1 or 2, **characterised in that** the monitoring element (20) comprises at least one wire arrangement.

4. Air-cooled dynamo-electric machine (1) according to one of the preceding claims, **characterised in that** a state of the insulation resistance at the end winding (8) is detected via the monitoring element (20).

5. Method for checking the insulation state of an end winding (8) of an air-cooled dynamo-electric machine (1), in particular an enclosed-ventilated dynamo-electric machine (1) having a stator (2) with a winding system which forms end windings (8) at the end faces of the stator (2), wherein at least the end winding (8) has at least one monitoring element (20) in its insulation layer for the purpose of monitoring the insulation thickness of the end winding (8), wherein the monitoring element (20) comprises at least one optical fibre arrangement, according to one of the preceding claims, comprising steps as follows:
- sending signals to the monitoring element (20) at time intervals which can be predetermined,
- receiving the return signals from the monitoring element (20),
- evaluating the return signals such that conclusions can be drawn in respect of the insulation state of the end winding (8).

6. Method for checking the insulation resistance according to claim 5, **characterised in that** a classification of the insulation state of the end winding (8) is performed on the basis of the received return signals.

## Revendications

1. Machine (1) dynamoélectrique à refroidissement par de l'air, notamment machine (1) dynamoélectrique blindée ventilée, comprenant un stator (2), un système d'enroulement, qui forme des têtes (8) de bobine sur les côtés frontaux du stator (2), dans laquelle au moins la tête (8) de bobine a, dans sa couche isolante, au moins un élément (20) de contrôle pour contrôler l'épaisseur isolante de la tête (8) de bobine, l'élément (20) de contrôle ayant au moins un agencement de fibre optique.

2. Machine (1) dynamoélectrique à refroidissement par de l'air suivant la revendication 1, **caractérisée en ce que** l'élément (20) de contrôle est prévu au moins au point de la tête (8) de bobine soumis à un courant (22) d'air de refroidissement.

3. Machine (1) dynamoélectrique à refroidissement par de l'air suivant la revendication 1 ou 2, **caractérisée en ce que** l'élément (20) de contrôle a au moins un agencement de fil métallique.

4. Machine (1) dynamoélectrique à refroidissement par de l'air suivant l'une des revendications précédentes, **caractérisée en ce qu'**une reconnaissance d'état de la résistance d'isolement à la tête (8) de bobine a lieu par l'élément (20) de contrôle.

5. Procédé de contrôle de l'état d'isolement d'une tête (8) de bobine d'une machine (1) dynamoélectrique à refroidissement par de l'air, notamment d'une machine (1) dynamoélectrique blindée ventilée, comprenant un stator (2), un système d'enroulement, qui forme des têtes (8) de bobine sur les côtés frontaux du stator (2), dans lequel au moins la tête (8) de bobine a, dans sa couche isolante, au moins un élément (20) de contrôle pour contrôler l'épaisseur isolante de la tête (8) de bobine, l'élément (20) de contrôle ayant au moins un agencement de fibre optique, suivant l'une des revendications précédentes par les stades suivants :
- à des intervalles de temps pouvant être donnés à l'avance, on envoie des signaux dans l'élément (20) de contrôle,
- on enregistre les signaux de retour de l'élément (20) de contrôle,
- on exploite les signaux de retour, de manière à tirer des conclusions sur l'état d'isolement de la tête (8) de bobine.

6. Procédé de contrôle de la résistance d'isolement suivant la revendication 5, **caractérisé en ce qu'**une classification de l'état d'isolement de la tête (8) de bobine a lieu par l'enregistrement des signaux de retour.
